# EUROPÄISCHE PATENTSCHRIFT

(11) **EP 0 931 174 B1**
(45) Veröffentlichungstag und Bekanntmachung des Hinweises auf die Patenterteilung: **09.06.2004**
(21) Anmeldenummer: 97909174.1
(22) Anmeldetag: 23.09.1997
(51) Int. Cl.: C23C 14/34, C23C 14/00, C23C 14/08

(54) **VERFAHREN ZUR HERSTELLUNG EINER WÄRMEDÄMMSCHICHT**
METHOD TO PRODUCE A HEAT INSULATING LAYER
PROCEDE POUR PRODUIRE UNE COUCHE CALORIFUGE

(30) Priorität: 23.09.1996 DE 19638979
(43) Veröffentlichungstag der Anmeldung: 28.07.1999
(73) Patentinhaber: SIEMENS AKTIENGESELLSCHAFT, 80333 München (DE)
(72) Erfinder: BEELE, Wolfram, D-40883 Ratingen (DE); JUNG, Thomas, D-38110 Braunschweig (DE); BRAND, Peter-Jochen, D-38100 Braunschweig (DE)
(86) Internationale Anmeldenummer: PCT/DE1997/002152
(87) Internationale Veröffentlichungsnummer: WO 1998/013531

(56) Entgegenhaltungen:
- DD-A- 294 511
- DE-A- 4 422 472
- US-A- 5 238 752
- PRATER J T ET AL: "CERAMIC THERMAL BARRIER COATINGS WITH IMPROVED CORROSION RESISTANCE" SURFACE AND COATINGS TECHNOLOGY, Bd. 32, 1.Januar 1987, Seiten 389-397, XP000564372
- THIELE E S: "DEPOSITION AND PROPERTIES OF YTTRIA-STABILIZED ZIRCONIA THIN FILMS USING REACTIVE DIRECT CURRENT MAGNETRON SPUTTERING" JOURNAL OF VACUUM SCIENCE AND TECHNOLOGY: PART A, Bd. 9, Nr. 6, 1.November 1991, Seiten 3054-3060, XP000335267
- SOHN Y H ET AL: "MICROSTRUCTURAL DEVELOPMENT IN PHYSICAL VAPOUR-DEPOSITED PARTIALLY STABILIZED ZIRCONIA THERMAL BARRIER COATINGS" THIN SOLID FILMS, Bd. 250, Nr. 1/02, 1.Oktober 1994, Seiten 1-7, XP000467879

## Beschreibung

Die Erfindung betrifft ein Verfahren zur Beschichtung eines Grundkörpers unter Vakuum mit einer Wärmedämmschicht.

Aus der US-PS 5,238,752 ist ein Wärmedämmschichtsystem mit einem intermetallischen Haftvermittlungsüberzug bekannt. Das Wärmedämmschichtsystem ist auf einen metallischen Grundkörper aufgebracht, insbesondere einen Cr-Co-Stahl für eine Flugtriebwerksschaufel. Als weitere Werkstoffe für den Grundkörper sind Kobalt- bzw. Nickel-Basis-Legierungen angegeben. Unmittelbar auf diesen metallischen Grundkörper ist eine intermetallische Haftvermittlungsschicht, insbesondere aus einem Nickel-Aluminit oder einem Platin-Aluminit aufgebracht. An diese Haftvermittlungsschicht schließt sich eine dünne keramische Schicht aus Aluminiumoxid an, auf die die eigentliche Wärmedämmschicht, insbesondere aus mit Yttriumoxid stabilisierten Zirkonoxid, aufgetragen ist. Diese keramische Wärmedämmschicht aus Zirkonoxid hat eine stabförmige Struktur, wobei die stabförmigen Stengel im wesentlichen senkrecht zur Oberfläche des Grundkörpers gerichtet sind. Hierdurch soll eine verbesserung der zyklischen thermischen Belastungsfähigkeit gewährleistet sein. Die Wärmedämmschicht wird mittels eines Elektronenstrahl-PVD(Physical Vapour Deposition)-Verfahrens auf den Grundkörper abgeschieden, wobei mit einer Elektronenstahlkanone aus einem metalloxidischen Körper Zirkon- und Yttriumoxide verdampft werden. Das Verfahren wird in einer Vorrichtung durchgeführt, in der der Grundkörper auf eine Temperatur von etwa 950°C bis 1000°C vorgeheizt wird. Der Grundkörper wird während des Beschichtungsvorganges in dem Strahl aus Metalloxid rotiert. Angaben über die stabförmige Kornstruktur sowie deren Eigenschaften sind der US-PS 5,238,752 nicht entnehmbar. Das Elektronenstrahl-PVD-Verfahren zur Herstellung keramischer Überzüge mit einer stabförmigen Kornstruktur ist weiterhin in der US-PS 5,087,477 sowie der US-PS 5,262,245 beschrieben, wobei die Abscheidung von Zirkonoxid auf einem Grundkörper in einer Sauerstoffatmosphäre erfolgt.

Weitere Verfahren und Beispiele zum Aufbringen eines Wärmedämmschichtsystems auf eine Gasturbinenschaufel sind beschrieben in der US-PS 5,514,482 sowie der US-PS 4,405,659. Gemäß der US-PS 4,405,659 soll es mit dem Elektronenstrahl-PVD-Verfahren möglich sein, eine Wärmedämmschicht aus mit Yttriumoxid stabilisierten Zirkonoxid aufzubringen, welches eine Schichtdicke von etwa 125 µm aufweist und eine stengelförmige Struktur besitzt. Die mittlere Querschnittsfläche eines Stengels soll größenordnungsmäßig 6,5 µm² betragen.

In der US-PS 4,321,310 sowie der US-PS 4,321,311 sind jeweils Wärmedämmschichtsysteme beschrieben, die eine Haftvermittlungsschicht zwischen dem Zirkonoxid und dem metallischen Grundkörper mit einer Legierung der Art MCrAlY aufweisen. Hierin bedeutet "M" eines der Metalle Kobalt, Nickel oder Eisen, "Cr" Chrom, "Al" Aluminium und "Y" Yttrium. Als mögliches Verfahren zur Herstellung einer Wärmedämmschicht aus Zirkonoxid wird ein PVD (Physical Vapor Deposition) -Verfahren angegeben.

In der WO 93/18199 A1 wird ebenfalls das Beschichten metallischer Bauteile, insbesondere Gasturbinenschaufeln aus einer Superlegierung, aus einem Verbundsystem mit einer Haftschicht und einer Wärmedämmschicht beschrieben. Das Aufbringen der Wärmedämmschicht erfolgt hierbei vorzugsweise mit dem Elektronenstrahl-PVD-Verfahren, wobei sich auch andere PVD-Verfahren, wie Sputtern sowie Abscheiden durch Lichtbogen, hierzu eignen könnten.

In dem Artikel "Zirconia thin film deposition on silicon by reactive gas flow sputtering: the influence of low energy particle bombardment" von T. Jung und A. Westphal, in Material Sience and Engineering, A 140, 191, Seiten 528 bis 533, ist das sogenannte reaktive Gasflußsputter-Verfahren angegeben zur Herstellung von Zirkoniumoxid-Schichten auf Halbleitersubstraten, insbesondere auf Silizium-Basis. Das Verfahren betrifft hierbei das kalte Abscheiden von Zirkoniumoxid, welches zu einem amorphen Aufwachsen des Zirkoniumoxides führt. Dieses amorphe Abscheiden erfolgt bei Substrattemperaturen von deutlich unter 800°C, wobei eine Aufheizung des Substrates unmittelbar verlustbehaftet über den Substratträger erfolgt. Dieser ist hierzu maximal selbst bis auf eine Temperatur von etwa 800°C aufheizbar, so daß unter Berücksichtigung der auftretenden Wärmeverluste eine Aufheizung des Substrats auf über 400 °C erreichbar ist. Ein Basisdruck liegt bei 10⁻⁷ Pa.

Zu dem Artikel korrespondiert die DD 294 511 A5 "Verfahren und Vorrichtung zum reaktiven Gasflußsputtern". Gemäß dem darin beschriebenen Verfahren wird ein Inertgas, insbesondere Argon, durch eine Hohlkathode geführt, in deren Inneren eine Anode angeordnet ist, so daß eine Ionisation der Argon-Atome stattfindet. Diese treffen auf der Kathode auf, wodurch Kathodenmaterial in den Innenraum der Hohlkathode gelangt und mit dem Inertgasstrom aus dieser herausgeführt wird. Bei dem Kathodenmaterial handelt es sich um reines Metall, welchem außerhalb der Hohlkathode Sauerstoff zugeführt wird, so daß eine vollständige Oxidation des Metalls, insbesondere Zirkoniums, stattfindet. Der Partialdruck des zugeführten Sauerstoffs liegt hierbei in der Größenordnung von 10⁻⁴ Pa. Der gesamte dynamische Druck in der Umgebung des zu beschichtenden Halbleiters beträgt etwa 13 Pa bis 24 Pa. Die Abscheidungsrate beträgt etwa 15 nm/min, wobei das Substrat eine Temperatur von etwa 400 °C aufweist. Die Hohlkathode ist als zylindrisches Rohr aus Zirkonium mit einem Reinheitsgrad von 99,7 %, ausgebildet.

Eine alternative Ausbildung der Hohlkathode zur Erreichung einer größeren Beschichtungsfläche und einer größeren Beschichtungsrate ist in dem Artikel "High rated desposition of alumina films by reactive gas flow sputtering" von T. Jung und A. Westphal, in Surface and Coatings Technology, 59, 1993, Seiten 171 bis 176 (hierzu korrespondiert die DE 42 35 953 A1), beschrieben. Die angegebene Hohlkathode ist linear aufgebaut in dem Sinne, daß in einem Gehäuse Platten aus Zirkonium nebeneinander angeordnet sind. Zwischen jeweils zwei benachbarten Platten ist ein Inertgasstrom hindurchführbar, so daß sich zwischen benachbarten Platten ein Plasma aus Inertgasatomen bildet. Die Platten können zudem eine Kuhlungseinrichtung, insbesondere Kühlkanäle, aufweisen. Mit der Hohlkathode wurden Testkörper aus Silizium, rostfreiem Stahl und Glas beschichtet und die Festigkeit der Aluminiumoxidschicht bei bis zu 200°C getestet. Aussagen über die Struktureigenschaften der Oxidschichten hinsichtlich Kristallitgröße und -orientierung sind in den beiden genannten Artikeln nicht enthalten.

In dem Artikel "Microstructural development in physical vapour-deposited partially stabilized zirconia thermal barrier coatings" von Y.H. Sohn, R.R. Biedermann und R.D. Sisson Jr in Thin Solid Films, 250 (1994), 1-7, wird allgemein über keramische Zirkonoxidbeschichtungen berichtet. Es werden Temperaturen von 700°C - 1030°C und ein Druck von 1,3 * 10⁻⁵ atm benutzt.

Aufgabe der Erfindung ist es, ein Verfahren zur Beschichtung eines Bauteils mit einer keramischen Wärmedämmschicht für hohe thermische Belastungen anzugeben.

Die Aufgabe wird gelöst durch ein Verfahren gemäß Anspruch 1.

Durch eine keramische Wärmedämmschicht ist ein thermischer Schutz des insbesondere metallischen Grundkörpers gewährleistet. Bekannte keramische Strukturen sind allerdings noch gegenüber zyklischen thermischen Belastungen anfällig und neigen unter Umständen zu einem Auseinanderbrechen und/oder Enthaften. Durch eine Mikrostruktur mit Keramikstengeln geringeren Durchmessers als der bisher erreichbare Durchmesser wird die Beständigkeit gegenüber Temperaturwechselbeanspruchungen deutlich erhöht. Eine Mikrostruktur mit Keramikstengeln mit einem mittleren Stengeldurchmesser von unter 2,5 µm, insbesondere zwischen 0,5 µm und 3,0 µm, besitzt eine hohe Dehnungstoleranz und eine hohe zyklische Belastungsfähigkeit aufgrund ihrer Ausrichtung im wesentlichen senkrecht zur Oberfläche des Grundkörpers und der feinen Stengelstruktur. Hierdurch werden Unterschiede in den Wärmeausdehnungskoeffizienten des insbesondere metallischen Grundwerkstoffes und der keramischen Wärmedämmschicht gut ausgeglichen. Solche geringe Stengeldurchmesser können durch ein für hohen Temperaturen entwickeltes reaktives Gasflußsputter-Verfahren erzielt werden.

Für eine gute Anbindung der keramischen Wärmedämmschicht an den metallischen Grundkörper, insbesondere aus einer Nickel-Basis-Legierung oder anderen zur Herstellung thermisch hochbelastbarer Bauteile geeigneter Legierungen, ist auf den Grundkörper eine metallische Haftschicht aufgetragen. Hinsichtlich der Schichtdicke von einigen Mikrometern sei auf die US-PS 5,238,752, die US-PS 4,321,310 sowie die US-PS 4,321,311 verwiesen. Die metallische Haftschicht besteht vorzugsweise aus einer Legierung der Art MCrAlY, wobei M für eines oder mehrere der Elemente Eisen, Kobalt oder Nickel, Cr für Chrom, Al für Aluminium und Y für Yttrium oder eines der Elemente der Seltenen Erden stehen. Als Haftschicht eignet sich ebenfalls eine intermetallische Verbindung, z.B. aus Nickelaluminit oder Platinaluminit.

Weiterhin vorteilhaft ist es, insbesondere im Hinblick auf eine Lebensdauerverlängerung und Anhaftung der Wärmedämmschicht an den Grundkörper, eine chemische Anbindung der Wärmedämmschicht an die metallische Haftschicht herzustellen. Dies wird beispielsweise durch eine dünne Schicht aus Aluminiumoxid (Al₂O₃) erreicht. Als Vermittlerschicht eignet sich ebenfalls eine Schicht aus einer ternären Al-Zr-O-Verbindung oder einer Al-O-N-Verbindung. Die ternäre AL-ZR-O-Verbindung, z.B. Al₂Zr₂O₇ eignet sich eignet sich vorzugsweise zur Anbindung einer Wärmedämmschicht, die Zirkonoxid aufweist. Bei anderen keramischen Wärmedämmschichten, beispielsweise aus Magnesiumoxid, können entsprechend andere Spinnelle Anwendung finden. Weiterhin geeignet ist eine Schicht aus Aluminiumnitrid oder einer Verbindung (Mischschicht) aus Aluminiumnitrid und Aluminiumoxid.

Die Wärmedämmschicht weist vorzugsweise eine metallkeramische Substanz, insbesondere Zirkonoxid (ZrO₂) , auf. Dieses Metalloxid ist vorzugsweise zur Vermeidung einer Phasenwandlung bei hohen Temperaturen mit einem Stabilisator, wie Yttriumoxid (Y₂O₃) hergestellt. Das Zirkonoxid ist vorzugsweise mit einem Gehalt von 3 Gew.-% bis 12 Gew.-%, insbesondere 7 Gew.-%, Yttriumoxid versetzt.

Eine keramische Wärmedämmschicht mit feiner Stengelstruktur von unter 2,5 µm mittlerem Stengeldurchmesser eignet sich besonders für einen thermischen Schutz von Bauteilen einer Gasturbine, die zyklischen Temperaturbelastungen von mehr als 1000°C ausgesetzt sind. Hierzu zählen vor allem Gasturbinenschaufeln sowie Komponenten eines Hitzeschildes einer Brennkammer einer Gasturbine. Dies gilt sowohl für stationäre Gasturbinen für einen Einsatz in Kraftwerken sowie für Flugtriebwerksturbinen. Selbstverständlich eignet sich die Wärmedämmschicht auch für andere hohen thermischen Belastungen ausgesetzte Bauteile.

In der Hohlkathodenanordnung, welche hohlzylindrisch mit einem kreisförmigen oder einem rechteckigen Querschnitt ausgeführt ist, wird durch Anlegen einer Gleichspannung zwischen Kathode und Anode eine Glimmentladung erzeugt. Die Anode kann beispielsweise stabförmig ausgebildet und in der Kathode angeordnet sein oder außerhalb, insbesondere die Kathode als Gehäuse umschließend, angeordnet sein. Durch ein in der Kathode entstehendes Plasma ist in jedem Fall zwischen dem Plasma und der Kathode ein so großer Spannungsabfall vorhanden, daß eine ständige Ionisation aufrechterhalten bleibt. Hierdurch wird durch die Gaseinlaßöffnung eintretendes Inertgas innerhalb der Hohlkathode ionisiert. Die ionisierten Inertgasatome treffen auf die kathodisch geschalteten Metallflächen der Hohlkathoden auf, gleichsam einem Ionenbeschuß,' und führen zu einer zumindest teilweisen Zerstäubung der Metallflächen. Das Kathodenmaterial besteht vorzugsweise aus einer Legierung aus Zirkon, wodurch durch den Ionenbeschuß Zirkonatome oder Zirkonatom-Cluster aus dem Kathodenmaterial herausgeschlagen werden. Entsprechend einer gewünschten Stabilisierung des anschließenden oxidierten und auf dem Grundkörper abgeschiedenen Zirkons ist dem Kathodenmaterial ein Stabilisatormetall, wie Yttrium, beigemischt oder zulegiert. Das Kathodenmaterial weist dementsprechend ein vorgegebenes Flächen- oder Volumenverhältnis von metallischem Zirkon und Yttrium auf.

Zur Oxidation des Zirkons und gegebenenfalls des beigemischten Yttriums ist in der Vorrichtung eine Oxidationsmittelzuführung außerhalb der Hohlkathode vorgesehen, durch die insbesondere Sauerstoff in entsprechenden Mengen zuführbar ist. Mit dem Gasstrom des Inertgases, insbesondere Argons, werden die zerstäubten als Metallatome und/oder Metall-Cluster vorliegenden Zirkonium- und Yttrium-Teilchen aus der Hohlkathodenanordnung heraustransportiert. Außerhalb der Hohlkathode werden diese in einer eingestellten Sauerstoff-Reaktionsatmosphäre vollständig oxidiert. Dies geschieht durch eine Zuführung von Sauerstoff durch die Oxidationsmittelzuführung derart, daß in Verbindung mit dem Inertgasstrom ein Eindringen des Sauerstoffs in die Hohlkathode unterbunden wird, so daß eine Oxidation des Kathodenmaterials weitgehend vermieden ist. Die oxidierten Metall-Teilchen schlagen sich auf dem Grundkörper als metalloxidkeramische Wärmedämmschicht nieder. Die Oxidation kann auch unmittelbar nach dem Niederschlag auf der Oberfläche des Grundkörpers stattfinden. Zur Erzielung der gewünschten Stengelstruktur erfolgt eine entsprechende Einstellung des Druckes innerhalb der Beschichtungsvorrichtung sowie der Temperatur, vor allem der Temperatur des Grundkörpers. Dieser wird über eine Beheizungseinrichtung auf' eine Temperatur von über 900°C, insbesondere auf 950°C bis etwa 1050 °C, erwärmt.

Mit der Beschichtungsvorrichtung zur Durchführung eines Hochtemperatur-Gasflußsputter-Verfahrens wird eine Entkopplung der Arbeitsatmosphäre für die Ionisation des Inertgases (Plasmaquelle) und des zu beschichtenden Bauteils erreicht. Gegenüber konventionellen PVD-Verfahren, insbesondere dem Elektronenstrahl-PVD-Verfahren, sind andere Wertebereiche der Kenngrößen, wie Druck des Restgases (Vakuumdruck, benötigtes Pumpniveau des Vakuumsystems), Arbeitsdruck sowie Verhältnis des Reaktivgases (Sauerstoff) zu den restlichen Arbeitsgasen gegeben. Die Atmosphäre an dem zu beschichtenden Bauteil kann für eine Durchführung des Verfahrens bei einem Restgasdruck von 10⁻³ mbar liegen, wobei die Obergrenze des Restdrucks in der Größenordnung von 10⁻² mbar liegen kann. Der Arbeitsdruck am Bauteil (Hauptkammer der Beschichtungsvorrichtung) liegt in der Größenordnung zwischen 0,2 bis 0,9 mbar. Das Verhältnis des Reaktivgases (Sauerstoff) zu dem ionisierten Inertgas (Plasmagas), z.B. Argon, kann im Bereich von 0,01 bis 0,04 liegen.

Die Atmosphäre der Plasmaquelle ist von der Atmosphäre des Bauteils im wesentlichen entkoppelt und weist einen Restgasdruck in der Größenordnung des Restgasdrucks an dem Bauteil auf. Der Arbeitsdruck der Gasströmung kann um etwa 0,02 mbar höher als der Arbeitsdruck an dem Bauteil sein. Durch die Gasausströmung der Quelle wird mithin der Arbeitsdruck am Bauteil, d.h. in der Hauptkammer des Beschichtungssystems, bestimmt. In der Hohlkathode liegt mithin ein Überdruck gegenüber der Hauptkammer vor. Das Verhältnis von Restgasbestandteilen, insbesondere Sauerstoff, zu dem ionisierten Inertgas (Plasmagas) liegt vorzugsweise unter 1%. Hierdurch kann die Ionisationsquelle (die Hohlkathodenanordnung) im Gleichstrom-Betrieb gefahren werden, da keine Oxidation der Beschichtungsquelle (Hohlkathode) mit einem instabilen Betriebszustand erfolgt. Hierdurch wird das Auftreten einer Glimmentladung sowie die Erzeugung von Lichtbogenplasmen aufgrund einer Oxidation des Kathodenmaterials vermieden.

Gegenüber bekannten Vorrichtungen zur Durchführung von PVD-Verfahren, insbesondere dem Elektronenstrahl-PVD-Verfahren; ist somit ein deutlich höherer Restgasdruck möglich, was zu einem vereinfachten und kostengünstigeren Vakuumsystem führt. Der Restgasdruck bei den bekannten Anlagen zur Erreichung einer stengelförmigen Wärmedämmschicht liegt im Bereich von 10⁻⁶ bis 10⁻⁵ mbar. Der Arbeitsdruck liegt bei den konventionellen Verfahren im Bereich von 10⁻³ bis 10⁻² mbar mit einer technisch sinnvollen Obergrenze kleiner 0,1 mbar und somit deutlich unter dem beim reaktiven Gasflußsputter-Verfahren möglichen Arbeitsdruck. Zudem ist bei den bekannten PVD-Verfahren ein hohes Verhältnis von Reaktivgas (Sauerstoff) zu weiteren Arbeitsgasen, wie Argon, Helium, etc., von 10 : 1 oder höher erforderlich. Bei dem erfindungsgemäßen Verfahren wird ein wesentlich niedrigeres Verhältnis benötigt, so daß auch die Zufuhreinrichtungen von Arbeitsgas und Reaktivgas deutlich einfacher und billiger ausführbar sind. Bei den bekannten PVD-Verfahren liegt zudem die Beschichtungsquelle ohne Entkopplung in der Hauptkammer und ist damit auch ungeschützt einer Oxidation ausgesetzt. Die Vorrichtung kann somit ohne Hochfrequenzgeneratoren oder echtzeit-geregelten Gleichstromgeneratoren ausgeführt sein.

Die Beheizungsvorrichtung ist hierbei vorzugsweise so ausgebildet, daß eine gleichmäßige Erwärmung, insbesondere Volumenerwärmung, des Grundkörpers gegeben ist. Selbst an Stellen des Grundkörpers mit hoher Massenkonzentration und großem Teilvolumen ist eine gleichmäßige Ankeimtemperatur für den gesamten Grundkörper erreicht.

Das Vakuum (Arbeitsdruck) innerhalb der Beschichtungsvorrichtung liegt im Bereich zwischen 0,3 mbar bis 0,9 mbar, beispielsweise bei 0,5 mbar. Zur Einstellung des gewünschten Vakuums ist eine Vakuumpumpeinrichtung vorgesehen, die einen einfachen Aufbau, z.B. eine Roots-Pumpen-Ausführung, aufweisen kann. Gegenüber dem herkömmlichen Elektronenstrahl-PVD-Verfahren, bei dem zur Erzielung eines Hochvakuums eine Drehschiebervorpumpe sowie eine Diffusionspumpe vorzusehen sind, ist die Vakuumpumpeinrichtung des Gasflußsputter-Verfahrens wesentlich einfacher ausführbar.

Zur Erzielung einer möglichst gleichmäßigen Beschichtung des Bauteils, insbesondere einer Gasturbinenschaufel, ist die Haltevorrichtung für eine Bewegung des Grundkörpers gegenüber der Gasauslaßöffnung ausgebildet. Vorzugsweise umfaßt die Halteeinrichtung einen Drehmechanismus, durch den eine kontinuierliche Drehung des Bauteils um seine Längsachse erfolgt.

Die auf ein Verfahren zur Beschichtung eines Grundkörpers unter Vakuum mit einer Wärmedämmschicht gerichtete Aufgabe wird dadurch gelöst, daß ein Inertgas in einer im wesentlichen sauerstoff-freien Atmosphäre ionisiert wird. Dies erfolgt. beispielsweise, indem das Inertgas durch eine Hohlkathode geführt und in dieser ionisiert wird. Die ionisierten Atome des Inertgases lösen aus einem metallischen Kathodenmaterial Metallatome und/oder Metallcluster heraus, die mit dem Inertgas aus der Hohlkathode herausgeführt und außerhalb der Hohlkathode mit Sauerstoff zu einem Metalloxid oxidiert werden. Es ist ebenfalls möglich, daß sich Metall auf dem Grundkörper abscheidet und dort durch auftreffenden Sauerstoff oxidiert wird. Das Metalloxid wird auf dem Grundkörper abgeschieden, der mit einer separaten Beheizungsvorrichtung auf eine vorgegebene Ankeim- und Kondensationstemperatur aufgeheizt wird. Hierdurch wird eine Wärmedämmschicht aus einem Metalloxid auf dem Grundkörper hergestellt, die eine feine stengelförmige Mikrostruktur aufweist, wobei der mittlere Stengeldurchmesser bei unter 2,5 µm, insbesondere in einem Bereich zwischen 0,5 µm bis 2,0 µm liegen kann. Diese Wärmedämmschicht hat eine besonders gute Beständigkeit gegenüber thermomechanischen Wechselbelastungen, wie es insbesondere bei mit einem Heißgas beaufschlagten Teilen einer Gasturbinenanlage, wie Turbinenschaufel und Isolationskomponenten, besonders vorteilhaft ist.

Gegenüber bekannten Elektronenstrahl-PVD-Verfahren wird als Kathodenmaterial ein Reinmetall oder eine Legierung aus einem Hauptmetall und zumindest einem Stabilisatormetall verwendet. Hierfür eignet sich bevorzugt eine Legierung aus Zirkon mit Yttrium, wobei das Yttrium dem Zirkon in einer solchen Menge und Verteilung zugesetzt ist, daß eine Wärmedämmschicht aus mit Yttriumoxid teilstabilisiertem Zirkonoxid entsteht.

Selbstverständlich eignen sich als Kathodenmaterial auch andere Metalle, die zu einem thermisch hochbeständigen Metalloxid führen, wie beispielsweise Magnesium. Die Verwendung einer metallischen Kathode anstelle eines Körpers aus Metalloxid; wie er beispielsweise bei den bekannten Elektronstrahl-PVD-Verfahren verwendet wird, hat den Vorteil, daß die hergestellte Wärmedämmschicht wesentlich feinstrukturierter ist. Darüber hinaus wird durch einen vollreaktiven Oxidationsprozeß der aus dem Kathodenmaterial herausgelösten metallischen Zerstäubungsmaterialien das Auftreten von Schicht fehlern vermieden, die beim Elektronenstrahl-PVD-Verfahren durch Fehler in dem Keramikkörper, wie inhomogene Porosität oder Fremdkörpereinflüsse, auftreten können. Zudem läßt sich gegenüber einem Keramikkörper das Kathodenmaterial einfacher und in höchster Reinheit herstellen.

Die Anbindung der Wärmedämmschicht aus Metalloxid erfolgt beispielsweise über die Ausbildung einer homogenen wachsenden Aluminiumoxid-Reaktionsschicht (Vermittlerschicht) zwischen der Wärmedämmschicht und einer Haftschicht aus einer Metalllegierung der Art MCrAlY. Das reaktive Gasflußsputter-Verfahren unter Verwendung einer von einem Inertgas durchströmten Hohlkathodenanordnung hat zudem den Vorteil, daß es in einem relativ groben Vakuum mit ausreichender Abscheidung von Metalloxiden auf den Grundkörper durchgeführt werden kann. Gegenüber den bekannten Elektronenstrahl-PVD-Verfahren mit komplizierten Elektronenstrahlablenkungs- und -fokussierungsfunktionen zeichnet sich das beschriebene Verfahren durch eine einfache Regelung bzw. Steuerung der Prozeßgrößen, wie Ankeimtemperatur, Vakuumdruck, Sauerstoffpartialdruck, Volumenstrom des Inertgases, Leistung der Hohlkathodenentladung aus. Die Bestimmung der zur Erreichung einer Struktur mit einem mittleren Stengeldurchmesser von unter 2,5 µm erforderlichen Prozeßgrößen erfolgt anhand des Thörnton-Diagramms zur PVD-Schichtstrukturausbildung, welches beispielsweise in Journal of Vacuum Science Technology, Vol. 11, 1974, Seiten 666 bis 670, von J.A. Thornton beschrieben ist. Hierin ist die Schichtstrukturausbildung in Abhängigkeit der Substrattemperatur, des Vakuumkammer-Gasdrucks und dem Schichtenenergiegehalt zur Aktivierung von Platzwechselprozessen beschrieben.

Die Anode verschleißt nicht, da sie bei Anordnung im Gaseinlaßbereich keiner Beschichtung oder Oxidation ausgesetzt ist. Verschleißteile wie Anode und Kathode können kleingehalten werden, insbesondere da die Anode innerhalb der Hohlkathode angeordnet ist, und somit einem direkten Beschuß von Elektronen oder Ionen nicht ausgesetzt ist. Die Anode kann zudem mit hohem Reinheitsgrad hergestellt werden. Vorteilhaft ist darüber hinaus, daß die zu zerstäubenden Materialien selbst als Kathode fungieren und nicht als Metalloxidkörper mit vorgegebenem Mischungsverhältnis eingefügt werden müssen.

Anhand der in der Zeichnung dargestellten Ausführungsbeispiele werden die Vorrichtung und das Verfahren zur Herstellung einer Wärmedämmschicht auf einem Grundkörper näher erläutert. Es zeigen:
- FIG 1: ein in einer Vorrichtung zur Beschichtung mit einer Wärmedämmschicht angeordnetes Bauteil und
- FIG 2: einen Längsschnitt durch das Bauteil in einem vergrößerten Maßstab.

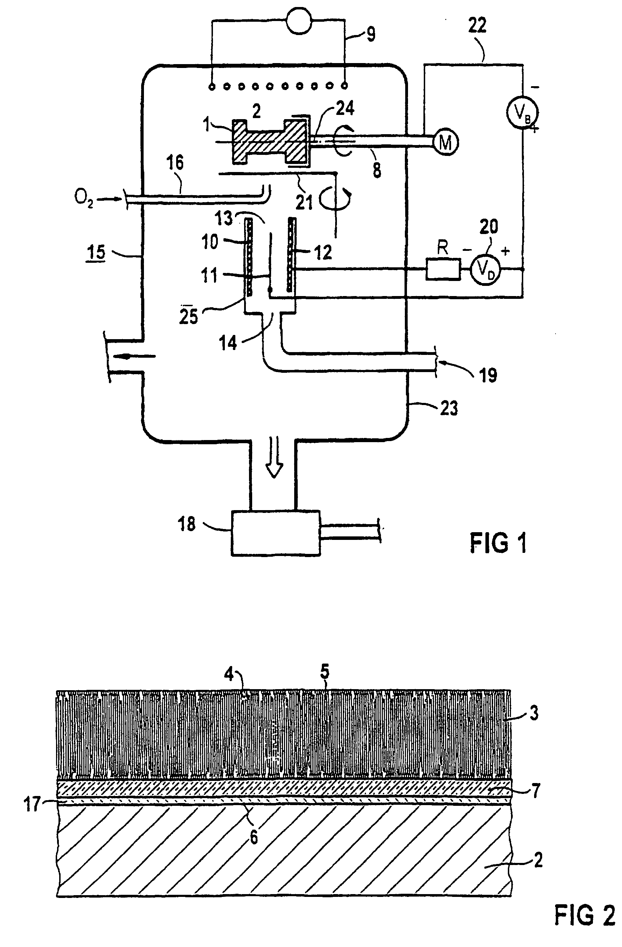

In Figur 1 ist schematisch und nicht maßstäblich ein prinzipieller Aufbau einer Beschichtungsvorrichtung 15 zur Durchführung eines reaktiven Gasflußsputter-Verfahrens dargestellt. Die Beschichtungsvorrichtung 15 weist ein Gehäuse 23 auf, in dem durch eine Vakuumpumpeinrichtung 18 ein Vakuum von 0.3 bis 0.9 mbar, insbesondere etwa 0,5 mbar, erzeugbar ist. Innerhalb des Gehäuses 23 ist eine Hohlkathode 10 mit kreiszylindrischem Querschnitt angeordnet. Für die Beschichtung großer Bauteile können mehrere solcher zylindrischer Hohlkathoden oder eine lineare Hohlkathode mit rechteckigem Querschnitt, die entlang einer Längsachse ausgerichtet sind/ist, verwendet werden. Innerhalb der Hohlkathode 10 ist eine stabförmige Anode 11 angeordnet, die über eine Gleichspannunsversorgung 20 mit der Hohlkathode 10 verbunden ist. Die Gleichspannungsversorgung 20 erzeugt beispielsweise eine Gleichspannung von 400 V bis 800 V, was zu einem Entladungsstrom von etwa 2 A führt. Die Hohlkathode 10 weist ein Kathodenmaterial 12 auf, welches als Hohlzylinder ausgebildet ist oder beispielsweise aus einzelnen die Innenwandung der Hohlkathodenanordnung 10 ausfüllenden Platten besteht. Die Hohlkathode 10 weist ein Außengehäuse mit einer Gaseinlaßöffnung 14 auf, die mit einer nicht dargestellten Gasversorgung verbunden ist, über die ein Inertgas 19, insbesondere Argon, in die Hohlkathode 10 eingeführt wird. Das Außengehäuse 25 dient der Führung des Inertgasstroms, der Unterbindung des Eindringens von Reaktivgas in die Hohlkathode 10 und der Abschirmung von Kathodenpotential führenden Oberflächen, die nicht zerstäubt werden sollen, insbesondere nicht dargestellte Kühlplatten des Kathodenmaterials 12. Der Gaseinlaßöffnung 14 gegenüberliegend hat die Hohlkathode 10 eine Gasauslaßöffnung 13, aus der das Inertgas 19 nach Durchlaufen des Bereiches zwischen Kathodenmaterial 12 und Anode 11 aus der Hohlkathode 10 herausströmt. Geodätisch oberhalb der Gasauslaßöffnung 13 ist mit einem Mündungsbereich eine Oxidationsmittelzuführung 16 angeordnet, durch die Sauerstoff in das Gehäuse 23 einführbar ist. Geodätisch oberhalb der Oxidationsmittelzuführung 16 ist ein Bauteil 1, eine Gasturbinenschaufel, mit einem Grundkörper 2 in einer Halteeinrichtung 8 gehalten. Die Halteeinrichtung 8 ist über eine Zusatzspannungsversorgung 22 mit der Hohlkathode 10 elektrisch verbindbar. Eine zwischen die Hohlkathode 10 und die Haltevorrichtung respektive das Bauteil 1 anlegbare Gleichspannung bewirkt eine Oberflächenreinigung des Bauteils 1 durch ionisierte Inertgasatome. Die Halteeinrichtung 8 hat vorzugsweise eine nicht näher dargestellte Antriebsvörrichtung, wodurch eine kontinuierliche Drehung des Bauteils 1 um seine Längsachse 24 stattfindet. Geodätisch oberhalb des Bauteils 1 ist eine Beheizungseinrichtung 9 zur Beheizung des Bauteils über Wärmestrahlung und/oder Konvektion angeordnet. Die Beheizungseinrichtung 9 kann selbstverständlich je nach Anforderung auch auf gleichem geodätischem Niveau neben dem Bauteil 1 angeordnet sein. Ebenfalls können alle Konfigurationsangaben in umgekehrter geodätischer oder in horizontaler Anordnung ausgeführt werden.

Zur Aufbringung einer Wärmedämmschicht 3, die vergrößert in Figur 2 dargestellt ist, wird das Bauteil 1 vorzugsweise auf eine Temperatur von über 900°C erwärmt. In die Hohlkathode 10 wird durch die Gaseinlaßöffnung 14 hindurch das Inertgas 19 eingeführt. Dieses wird aufgrund der in der Hohlkathode 10 herrschenden Spannungsdifferenz in Form einer Glimmentladung ionisiert, wobei die ionisierten Gasatome auf das Kathodenmaterial 12 auftreffen. Dieses ist vorzugsweise ein Reinmetall wie Zirkon, welches in einer vorgegebenen Volumenverteilung mit einem Stabilisatormetall, beispielsweise Yttrium, versetzt ist. Durch die ionisierten Inertgasatome werden aus dem Kathodenmaterial 12 Metallatome und/oder Metallcluster herausgelöst und in dem Inertgasstrom 19 in Richtung des Bauteiles 1 transportiert. Durch den über die Oxidationsmittelzuführung 16 zugeführten Sauerstoff findet eine vollständige Oxidation der Metallatome, insbesondere zur Zirkonoxid und Yttriumoxid, statt. Diese scheiden sich, wenn ein geodätisch unterhalb des Bauteiles 1 angeordneter Abschatter 21 zur Seite gedreht ist, auf dem Grundkörper 2 des Bauteils 1 in Form einer teilstabilisierten metalloxidkeramischen Wärmedämmschicht 3 ab. Durch eine Rotation des Bauteils 1 um seine Längsachse 24 findet eine gleichmäßige Beschichtung des Bauteils 1 statt. Durch eine auf dem Grundkörper 2 aufgebrachte metallische Haftschicht 17, beispielsweise aus Eisen, Nickel und/oder Kobalt sowie Chrom, Aluminium, Yttrium, und eine darauf aufgewachsene Vermittlerschicht 7, beispielsweise aus Aluminiumoxid, findet eine thermisch stabile chemische Anbindung des Metalloxids an den Grundkörper 2 statt.

Die Abscheidung des Metalloxids findet in Form der Wärmedämmschicht 3 mit einer feinstrukturierten Stengelstruktur 4 statt (siehe Figur 2). Die gebildeten Keramikstengel 5 sind überwiegend normal zur Oberfläche 6 des Grundkörpers 2 orientiert und haben einen Stengeldurchmesser von im Mittel unter 5,0 µm, insbesondere, wie anhand von Versuchen gezeigt werden konnten, zwischen 0,5 µm und 3,0 µm. Durch diese feinstrukturierte Stengelstruktur 4 mit einem geringen Stengeldurchmesser wird eine besonders hohe Beständigkeit der Wärmedämmschicht 3 gegenüber thermischen Wechselbelastungen mit Temperaturdifferenzen von bis zu über 1000 °C erreicht.

Die Erfindung zeichnet sich mithin dadurch aus, daß über ein einfach kontrollierbares und regelbares Verfahren eine thermisch stabile Wärmedämmschicht auf einem metallischen Grundkörper abgeschieden wird. Diese Wärmedämmschicht, welche über ein oder mehrere Zwischenschichten thermomechanisch stabil an den metallischen Grundkörper angekoppelt ist, hat eine feinstrukturierte Stengelstruktur mit einem mittleren Stengeldurchmesser von unter 5,0 µm. Vor allem hierdurch wird eine hohe thermische Wechselbeständigkeit der Wärmedämmschicht erreicht, die sich dadurch besonders für die Verwendung bei thermische hoch belasteten Bauteilen, wie einem Heißgas ausgesetzten Komponenten einer Gasturbinenanlage, insbesondere Gasturbinenschaufeln und Brennkammerauskleidungen, eignet.

## Patentansprüche

1. Verfahren zur Beschichtung eines Grundkörpers (2) unter Vakuum mit einer Wärmedämmschicht (3) zumindest teilweise bestehend aus Keramikstängeln (5) mittels reaktiven Gasflusssputterns,
bei dem ein Inertgas in einer im wesentlichen sauerstoff-freien Atmosphäre ionisiert wird,
das ionisierte Inertgas aus einem metallischen Kathodenmaterial Metallatome herauslöst,
welche mit dem Inertgas in Richtung des Grundkörpers (2) mitgeführt werden und welchen vor Erreichen des Grundkzörpers (2) Sauerstoff zugeführt wird,
so dass sich ein Metalloxid bildet,
welches auf dem Grundkörper (2) abgeschieden wird oder sich Metall auf dem Grundkörper (2) abscheidet
und durch auftreffenden Sauerstoff oxidiert wird,
wobei der Grundkörper (2) auf eine vorgegebene Ankeimtemperatur von über 800°C geheizt wird,
wobei das Vakuum im Bereich zwischen 0,3mbar und 0,9mbar liegt.

2. Verfahren nach Anspruch 2, bei dem die Ankeimtemperatur auf zwischen 950°C und 1050°C eingestellt wird.

3. Verfahren nach einem der Ansprüche 1 oder 2, bei dem die Prozessgrößen, wie Ankeimtemperatur, Vakuumdruck, Sauerstoffpartialdruck, Volumenstrom des Inertgases, so gewählt werden, dass die Wärmedämmschicht (3) Keramikstängel (5) mit einem Stängeldurchmesser von unter 2,5 µm, insbesondere zwischen 0,5 µm und 2,0 µm, aufweist.

## Claims

1. Method of coating a parent body (2) under vacuum with a heat-insulating layer (3) at least partially consisting of ceramic stems (5) by means of reactive gas flow sputtering,
in which method an inert gas is ionized in an essentially oxygen-free atmosphere,
and the ionized inert gas releases from a metallic cathode material metal atoms,
which are carried along with the inert gas in the direction of the parent body (2) and to which oxygen is fed before the parent body (2) is reached,
so that a metal oxide forms
and is deposited on the parent body (2) or metal is deposited on the parent body (2)
and is oxidized by oxygen coming into contact with it,
the parent body (2) being heated to a predetermined germinating temperature of over 800 °C,
the vacuum being within the range of between 0.3 mbar and 0.9 mbar.

2. Method according to Claim 1, in which the germinating temperature is set to between 950 °C and 1050 °C.

3. Method according to either of Claims 1 and 2, in which the process variables, such as germinating temperature, vacuum pressure, oxygen partial pressure, volumetric flow of the inert gas, are selected in such a way that the heat-insulating layer (3) has ceramic stems (5) of a diameter of less than 2.5 µm, in particular between 0.5 µm and 2.0 µm.

## Revendications

1. Procédé de revêtement d'une pièce (2) de base sous vide d'une couche (3) calorifuge constituée au moins en partie de structures (5) basaltiques en céramique au moyen d'une pulvérisation cathodique réactive à flux de gaz,
dans lequel on ionise un gaz inerte dans une atmosphère sensiblement exempte d'oxygène,
le gaz inerte ionisé détache d'un matériau métallique de cathode des atomes de métal
qui sont entraînés avec le gaz inerte en direction de la pièce (2) de base et auxquels on apporte, avant qu'ils atteignent la pièce (2) de base, de l'oxygène,
de manière à former un oxyde métallique,
qui se dépose sur la pièce (2) de base ou que du métal se dépose sur la pièce (2) de base et soit oxydé par de l'oxygène incident,
la pièce (2) de base étant portée à une température prescrite de formation de germes supérieure à 800°C,
le vide étant de l'ordre de 0,3 mbar à 0,9 mbar.

2. Procédé suivant la revendication 2, dans lequel on règle la température de formation de germes entre 950°C et 1050°C.

3. Procédé suivant l'une des revendications 1 ou 2, dans lequel on choisit les grandeurs opératoires comme la température de formation de germes, la pression du vide, la pression partielle de l'oxygène, le courant en volume du gaz inerte, de façon à ce que la couche (3) calorifuge ait des structures (5) basaltiques en céramique ayant un diamètre des aiguilles inférieur à 2,5 µm, notamment compris entre 0,5 µm et 2,0 µm.
